# EUROPÄISCHE PATENTSCHRIFT

(11) **EP 2 664 065 B1**
(45) Veröffentlichungstag und Bekanntmachung des Hinweises auf die Patenterteilung: **04.05.2016**
(21) Anmeldenummer: 12700806.8
(22) Anmeldetag: 12.01.2012
(51) Int. Cl.: H03K 17/965, B60K 37/06

(54) **BEDIENEINHEIT FÜR EINE FAHRZEUGKOMPONENTE**
CONTROL DEVICE FOR A VEHICLE MODULE
UNITÉ DE COMMANDE POUR UN APPAREIL DE VÉHICULE

(30) Priorität: 13.01.2011 DE 102011008509
(43) Veröffentlichungstag der Anmeldung: 20.11.2013
(73) Patentinhaber: Behr-Hella Thermocontrol GmbH, 70190 Stuttgart (DE)
(72) Erfinder: LAMMINGER, Egbert, 59494 Soest (DE)
(74) Vertreter: von Kreisler Selting Werner - Partnerschaft von Patentanwälten und Rechtsanwälten mbB
(86) Internationale Anmeldenummer: PCT/EP2012/050452
(87) Internationale Veröffentlichungsnummer: WO 2012/095496

(56) Entgegenhaltungen:
- EP-A2- 1 898 295
- DE-A1-102005 025 021
- US-A1- 2009 161 325

## Beschreibung

Die Erfindung betrifft eine Bedieneinheit für eine Fahrzeugkomponente, bei der es sich insbesondere um ein Radio, ein CD- und/oder DVD-Abspielgerät, ein Navigationsgerät, ein Infotainment-Gerät, ein Heizungs- oder Klimasteuergerät oder ein Mensch-Maschine-Interface handeln kann.

Die verschiedensten Fahrzeugkomponenten werden manuell über Bedieneinheiten bedient, die im Regelfall im Fahrzeuginnenraum angeordnet sind und mit einer zum Fahrzeuginnenraum weisenden Vorderwand versehen sind. Auf der Vorderwand sind beispielsweise Symbolfelder angeordnet, die sich an Drucktasten, Drehknöpfen, Kipp- oder Wipptasten oder aber auch auf feststehenden Flächen befinden.

Aufgrund der zunehmenden Komplexität von Bedieneinheiten, über die insbesondere mehrere Fahrzeugkomponenten bedient werden können, geht man mehr und mehr dazu über, über die Erfassung einer Annäherung an ein Symbolfeld mit beispielsweise dem Finger einer Hand und/oder über die Erfassung der Berührung des Symbolfeldes durch den Finger einer Hand im Vorfeld der eigentlichen Bedienung der die Bedieneinheit bedienenden Person beispielsweise über eine Anzeige oder in anderer Art und Weise nähere Informationen über beispielsweise die auszuwählenden Bedienfunktionen anzugeben. So könnte beispielsweise auf einem Bildschirm ein Untermenü angezeigt werden, das sich über das manuell ausgewählte Symbolfeld bedienen lässt. Hierzu werden Näherungssensoren benötigt, die zumeist kapazitiv arbeiten. Man spricht insoweit auch von der "kapazitiven Vorfelderkennung".

Bedieneinheiten für Fahrzeugkomponenten, die über kapazitive Näherungssensoren verfügen, weisen zumeist ein Gehäuse auf, das zur Bedienerseite hin durch eine Vorderwand oder allgemein ein Abdeckelement (beispielsweise Frontblende) abgeschlossen ist. In einem gewissen Abstand hinter der Frontblende befindet sich zumeist eine Trägerplatte in Form einer Leiterplatine, die neben Leiterbahnen auch die verschiedensten elektrischen, elektronischen und mechanischen Bauteile aufweist. Für eine zuverlässige Annährungs- und Berührungsdetektion eines Symbolfeldes ist es von Vorteil, wenn die kapazitiv arbeitende Sensorelektrode des Näherungssensors möglichst dicht hinter der Vorderwand angeordnet ist. Zu diesem Zweck wird die Sensorelektrode zumeist von einem Sensorträgerkörper gehalten, der die unterschiedlichsten Ausgestaltungen aufweisen kann. Beispiele für Bedieneinheiten der zuvor genannten Art finden sich in WO-A-2008/015225, EP-A-1 739 839, DE-A-10 2007 025 564, DE-A-10 2005 029 512, DE-A-10 2005 029 503 und DE-A-10 2005 025 021.

Aus DE-A-102 50 395 ist ein kapazitiver Annäherungs- und/oder Berührungssensor bekannt, der einen elektrisch leitfähigen Kunststoffkörper als Sensor aufweist. Der Kunststoffkörper ist auf den Rand einer Trägerplatine aufgesteckt und ragt von dieser ab. Die Trägerplatine verläuft im Wesentlichen rechtwinklig zu einer Berührungsfläche (z. B. einem Abdeckelement), an dessen Unterseite der Kunststoffkörper anliegt.

Aus DE-A-40 27 761 ist es bekannt, an einer Platine mehrere, dessen Rand umgreifende, elektrisch leitende Kontaktflächen auszubilden, die zwecks Anschlusses der Platine von Federklemmen aufgenommen sind.

In US-A-2009/0161325 ist ferner ein in einer Hand zu haltendes elektronisches Gerät beschrieben, dessen Gehäuse einen umlaufenden Seitenrand aufweist. Innerhalb des Geräts und nahe dem Seitenrand befindet sich ein kapazitiver Sensor, der Sensorelektroden aufweist, die nach Art von Durchkontaktierungen im Randbereich einer in dem Gerät angeordneten Platine ausgebildet sind.

Aufgabe der Erfindung ist es, eine Bedieneinheit für eine Fahrzeugkomponente mit kapazitivem Näherungssensor dahingehend zu verbessern, dass der Sensorelektroden-Trägerkörper einen vereinfachten Aufbau aufweist.

Zur Lösung dieser Aufgabe wird mit der Erfindung eine Bedieneinheit für eine Fahrzeugkomponente, insbesondere für ein Radio, ein CD- und/oder DVD-Abspielgerät, ein Navigationsgerät, ein Infotainment-Gerät, ein Heizungs- oder Klimasteuergerät oder für ein Mensch-Maschine-Interface, vorgeschlagen, wobei die Bedieneinheit versehen ist mit den Merkmalen des Anspruchs 1. Einzelne Ausgestaltungen der Erfindung sind Gegenstand der Unteransprüche.

Die erfindungsgemäße Bedieneinheit weist einen Sensorträgerkörper auf, der als Leiterplatine ausgeführt ist, die im Wesentlichen quer oder in einer anderen (Schräg-)Stellung winklig zur Bedieneinheit-Vorderwand hinter dieser angeordnet ist. Bei Vorhandensein einer Trägerplatte hinter der Vorderwand der Bedieneinheit steht also die Sensorleiterplatine im Wesentlichen hochkant oder schräg auf der Trägerplatte. Die Sensorleiterplatine befindet sich mit einem ihrer Randabschnitte direkt hinter der Vorderwand der Bedieneinheit. Der zur Vorderwand nächstliegende Randbereich der Sensorleiterplatine bildet den 5ensarelektrodenrandabschnitt, der aus der Randfläche, die die beiden Hauptseitenflächen der Sensorleiterplatine verbindet, und den zur Randfläche benachbarten Bereichen der Hauptseitenflächen besteht. Mit anderen Worten erstreckt sich der Sensorelektrodenrandabschnitt über drei Flächen der Sensorleiterplatine. In dem Sensorelektrodenrandabschnitt ist mindestens eine elektrisch leitende Fläche, nämlich die Sensorelektrode, ausgebildet. Diese Fläche ist beispielsweise durch Aufbringen von elektrisch leitendem Material (Kupfer, Aufkupferung, Lot) gebildet, wie es bei der Herstellung von Leiterplatinen und insbesondere von Leiterbahnen auf Leiterplatinen bekannt ist.

Die Verwendung einer Leiterplatine als Sensorelektrodenträgerkörper ist denkbar einfach zu realisieren und auch insofern von Vorteil, da zumeist hinter der Vorderwand der Bedieneinheit eine ebenfalls aus Leiterplatinenmaterial bestehende Trägerplatte angeordnet ist. Man greift also für den Sensorträgerkörper auf das gleiche Material wie für die Hauptleiterplatine zurück. Die Bearbeitung von Leiterplatinen ist denkbar einfach und zu Genüge erprobt. Das Leiterplatinenmaterial ist robust und arbeitet auch bei den insbesondere im Automotive-Bereich geforderten Temperaturbereichen zuverlässig. Damit kann also ein funktionstüchtiger kapazitiver Näherungssensor aufgebaut und erstellt werden. Durch die Höhe der Sensorleiterplatine kann dessen Sensorelektrodenrandabschnitt bis unmittelbar an die Vorderwand hin positioniert werden. Die Höhe der aufragenden Sensorleiterplatine ist dabei abhängig von dem Abstand einer Trägerplatte hinter der Vorderwand der Bedieneinheit, wobei die Sensorleiterplatine dann beispielsweise auf dieser Trägerplatte angeordnet und von dieser gehalten ist.

Die erfindungsgemäße Sensorleiterplatine kann beispielsweise in einen Drucktastenkörper, der insbesondere mehrere Symbolfelder aufweist, integriert sein. Es ist aber auch möglich, dass das Symbolfeld bzw. mehrere Symbolfelder direkt auf der Vorderwand der Bedieneinheit und damit auf einem starren Element der Bedieneinheit angeordnet sind. Die durch das Symbolfeld angezeigte Bedienfunktion wird also dann lediglich durch das Auflegen oder Annähern beispielsweise eines Fingers einer Hand ausgelöst. Alternativ ist es möglich, dass mehrere nebeneinander angeordnete Symbolfelder an der Vorderwand einer Drucktaste ausgebildet sind, die selbst einen Hub ausführt, wobei durch die kapazitive Erfassung desjenigen Symbolfeldes, das beim Niederdrücken der Drucktaste von beispielsweise dem Finger einer Hand berührt wird, die von der die Bedieneinheit bedienenden Person ausgewählte Bedienfunktion ermittelt wird.

In vorteilhafter Weiterbildung der Erfindung kann die Sensorleiterplatine beispielsweise auch noch weitere insbesondere elektrooptische Bauteile, wie beispielsweise eine Hinterleuchtungslichtquelle für das Symbolfeld, aufweisen. Hierbei ist dann vorgesehen, dass der Sensorelektrodenrandabschnitt der Sensorleiterplatine eine Randaussparung mit einem gegenüber der Sensorelektrode zurückspringenden Randabschnitt aufweist und dass auf mindestens einer der beiden gegenüberliegenden Hauptseitenflächen der Sensorleiterplatine nahe dem zurückspringenden Randabschnitt eine Symbolfeld-Hinterleuchtungslichtquelle mit einer optischen Lichthauptabstrahlachse angeordnet ist, die im Wesentlichen parallel zur Erstreckung der Sensorleiterplatine und über den zurückspringenden Randabschnitt hinaus verläuft. Nachdem die Hinterleuchtungslichtquelle auf einer Hauptseitenfläche der Sensorleiterplatine angeordnet ist, und zwar nicht an dem Sensorelektrodenrandabschnitt, sondern gegenüber diesem zurückversetzt, würde ohne entsprechende Maßnahmen die Sensorleiterplatine in ihrem bezogen auf die Lichtausbreitungsrichtung zwischen der Lichtquelle und dem Sensorelektrodenrandabschnitt befindlichen Bereich zu einer Abschattung fuhren. Daher ist bei dieser Ausgestaltung der Erfindung eine Randaussparung in der Sensorleiterplatine vorgesehen, so dass das von der Hinterleuchtungslichtquelle austretende Licht sich in Lichtausbreitungsrichtung betrachtet über beide Hauptseitenflächen der Sensorleiterplatine hinaus ausbreiten kann.

Zur Beeinflussung des sensitiven Bereichs vor der Vorderwand, innerhalb dessen eine Annäherung an ein Symbolfeld und eine Berührung des Symbolfeldes kapazitiv erkannt werden soll, ist es bekannt, neben einer Sensorelektrode auch eine Abschirmelektrode vorzusehen. Diese Abschirmelektrode ist im Regelfall mit Masse verbunden und schirmt sozusagen bestimmte räumliche Bereiche gegenüber der Sensorelektrode ab. In einer vorteilhaften Ausgestaltung der Erfindung ist diese Abschirmelektrode (oder sind mehrere dieser Abschirmelektroden) auf der Sensorleiterplatte ausgebildet und einer oder mehreren Sensorelektroden zugeordnet.

In weiterer zweckmäßiger Ausgestaltung der Erfindung ist vorgesehen, dass auf den Sensorelektrodenrandabschnitt der Sensorleiterplatine zur Vergrößerung der zum Symbolfeld weisenden elektrisch leitenden Sensorfläche der Sensorelektrode ein elektrisch leitendes Material aufweisendes Bauteil aufgesteckt oder in anderer Weise unter im Wesentlichen quer zu den Hauptseiten der Sensorleiterplatine gerichteten Erstreckung über zumindest eine der Hauptseiten hinaus mit dem Sensorelektrodenrandabschnitt der Sensorleiterplatine verbunden ist. Bei dieser Weiterbildung der Erfindung ist es von Vorteil, dass damit die hinter der Vorderwand angeordnete sowie einem Symbolfeld zugeordnete Sensorelelctrodenfläche vergrößert werden kann. Durch die Verwendung der Leiterplatine steht an sich zunächst einmal lediglich die relativ schmale Randfläche, deren Breite durch die Dicke der Sensorleiterplatine bestimmt ist, zur Verfügung. Die sich von der Randfläche aus erstreckenden Sensorflächen auf den beiden Hauptseitenflächen der Sensorleiterplatine wirken selbstverständlich auch kapazitiv. Zweckmäßig ist es aber, wenn die schmale Randfläche verbreitet werden könnte. Dies gelingt durch Aufstecken eines U-förmigen Bauteils mit breiter Basis und davon aufragenden, an den Hauptseitenflächen der Sensorleiterplatine anliegenden Schenkeln. Ein derartiges Bauteil könnte beidseitig über die Randfläche überstehen. Alternativ ist es auch möglich, wenn dieses Bauteil nicht durch Aufstecken sondern auf andere Art und Weise mechanisch und elektrisch mit der Sensorleiterplatine verbunden ist.

In weiterer vorteilhafter Ausgestaltung der Erfindung kann vorgesehen sein, dass die Sensorleiterplatine Anschlussfelder zur elektrischen Verbindung der Sensorelektrode und, sofern vorhanden, der Abschirmelektrode mit einer Trägerplatte aufweist. Hierbei ist es ferner zweckmäßig, wenn die Anschlussfelder elektrisch leitend mit Steckerstift- oder Steckerbuchsenelementen eines Kabelverbinders verbindbar oder an Randvorsprüngen der Sensorleiterplatine zum Eintauchen in Kontaktaufnahmen oder -ausnehmungen der Trägerplatte angeordnet sind.

Die Erfindung wird nachfolgend anhand mehrerer Ausführungsbeispiele und unter Bezugnahme auf die Zeichnung näher erläutert. Im Einzelnen zeigen dabei:
- Fign. 1 und 2: perspektivische bzw. Schnittdarstellungen eines kapazitiven Näherungssensors für eine Bedieneinheit gemäß einem ersten Ausführungsbeispiel,
- Fign. 3 und 4: eine beispielhafte Ausgestaltung eines kapazitiven Sensors,
- Fign. 5 und 6: weitere Darstellungen eines zusätzlichen Ausführungsbeispiels eines kapazitiven Näherungssensors,
- Fign. 7 und 8: perspektive und Schnittansichten eines beispielhaften kapazitiven Näherungssensors und
- Fig. 9: perspektivisch die Darstellung eines letzten Ausführungsbeispiels eines kapazitiven Näherungssensors.

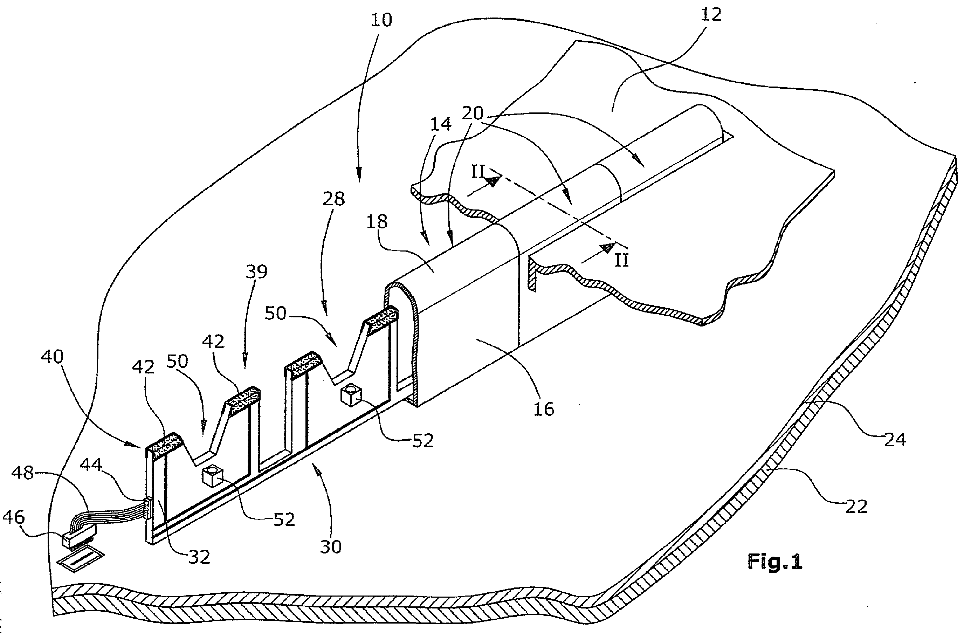

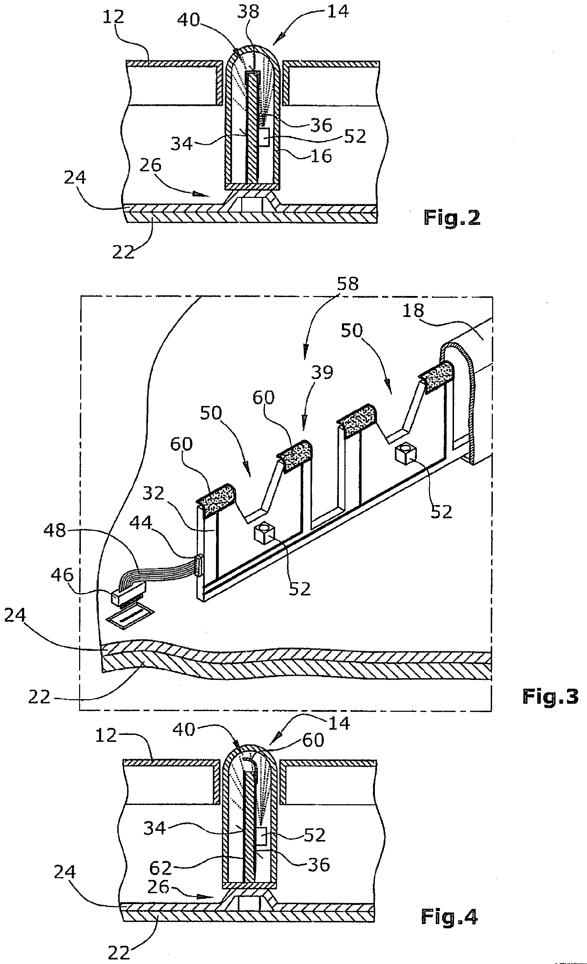

In den Fign. 1 und 2 ist ein erstes Ausfuhrungsbeispiel eines kapazitiven Näherungssensors bei einer Bedieneinheit 10 gezeigt. Die Bedieneinheit 10 weist ein nicht vollständig dargestelltes Gehäuse auf, das eine Vorderwand 12 oder dergleichen Frontblende aufweist. Innerhalb der Vorderwand 12 befindet sich eine in diesem Ausfuhrungsbeispiel längliche Drucktaste 14, deren langgestreckter Drucktastenkörper 16 eine in diesem Ausführungsbeispiel konvex gewölbte Vorderwand 18 mit in diesem Fall fünf Symbolfeldern 20 aufweist. Innerhalb des Gehäuses befindet sich hinter der Drucktaste 14 eine Hauptleiterplatine oder dergleichen Trägerplatte 22 mit einer Silikon-Schaltmatte 24. Die Silikon-Schaltmatte 24 weist in bekannter Weise einen der Bildung eines Schaltkontakts dienenden flexiblen Vorsprung 26 auf, an dem der Drucktastenkörper 16 mit einer gewissen Vorspannung anliegt. Beim Niederdrücken des Drucktastenkörpers 16 wird dann der Vorsprung 26 niedergedrückt, bis er die Hauptleiterplatine 22 kontaktiert, womit dann ein Schaltkontakt ausgeführt ist. Der Drucktaste 14 können mehrere derartige Vorsprunge 26 zugeordnet sein.

Erfindungsgemäß ist der Drucktastenkörper 16 mit einem innenliegenden Näherungssensor 28 versehen, der einen Sensorträgerkörper 30 aufweist, der als Sensorplatine 32 ausgebildet ist. Die Sensorplatine 32 steht in dem Drucktastenkörper 16 hochkant und weist zwei Hauptseitenflächen 34,36 und eine diese verbindende Randfläche 38 auf, die einen Sensorelektrodenrandabschnitt 39 der Sensorplatine 32 bilden. Innerhalb des zur Randfläche 38 jeweils benachbarten Bereichs jeder der Hauptseitenflächen 34 und 36 sowie innerhalb der Randfläche 38 befinden sich mehrere elektrisch leitende, freiliegende Felder 40, die einzelne Sensorelektroden 42 bilden. In diesem Ausführungsbeispiel sind jeweils zwei Sensorelektroden 42 jeweils einem Symbolfeld 20 zugeordnet. Die Kontaktierung der Sensorelektroden 42 ist in Fig. 1 gezeigt, wobei die Sensorplatine 32 elektrisch über Verbinder 44,46 und ein Kabel 48 mit der Hauptleiterplatine 22 verbunden ist.

Zwischen jeweils zwei einem Symbolfeld 20 zugeordneten Sensorelektroden 42 weist die Sensorplatine 32 eine Randaussparung 50 auf, benachbart zu der auf einer der beiden Hauptseitenflächen 34,36 eine bezogen auf die Darstellungen in den Fign. 1 und 2 nach oben abstrahlende LED als Hinterleuchtungslichtquelle 52 angeordnet ist.

Zur Einschränkung des räumlich sensitiven Bereichs vor der Vorderwand 12 der Bedieneinheit 10 kann auf einer der beiden Hauptseitenflächen 34,36 der Sensorplatine 32 eine Abschirmelektrode angeordnet sein, die im Ausfuhrungsbeispiel der Fign. 1 und 2 nicht dargestellt ist. Die Abschirmelektrode ist beispielsweise mit Masse verbunden, während die Sensorelektroden 42 mit einer ebenfalls nicht gezeigten Auswertschaltung bzw. -elektronik verbunden sind.

Eine beispielhafte Ausgestaltung eines Näherungssensors 58 ist in den Fign. 3 und 4 gezeigt. Soweit die Einzelbestandteile des Näherungssensors 58 der Fign 3 und 4 denjenigen der Fign. 1 und 2 entsprechend bzw, identisch mit diesen sind, sind sie in den Fign. 3 und 4 mit den gleichen Bezugszeichen wie in den Fign. 1 und 2 versehen. Dies gilt auch für die weiter unten noch zu beschreibenden weiteren Alternativen.

Der Unterschied des kapazitiven Näherungssensors 58 der Fign. 3 und 4 gegenuber dem Näherungssensor 28 der Fign. 1 und 2 besteht in der Ausbildung der Sensorelektroden 42 durch zusätzliche elektrisch leitende und damit Sensorflächen bildende Fahnen 60, die zumindest über eine der Hauptseiten 34,36 der Sensorplatine 32 übersteht. Ferner weist der Näherungssensor 58 gemäß den Fign. 3 und 4 eine Abschirmelektrode 62 auf, die entweder auf einer der beiden Hauptseitenflächen 34,36 durchgehend oder aber entsprechend der Aufteilung der Sensorelektroden 60 unterteilt ist.

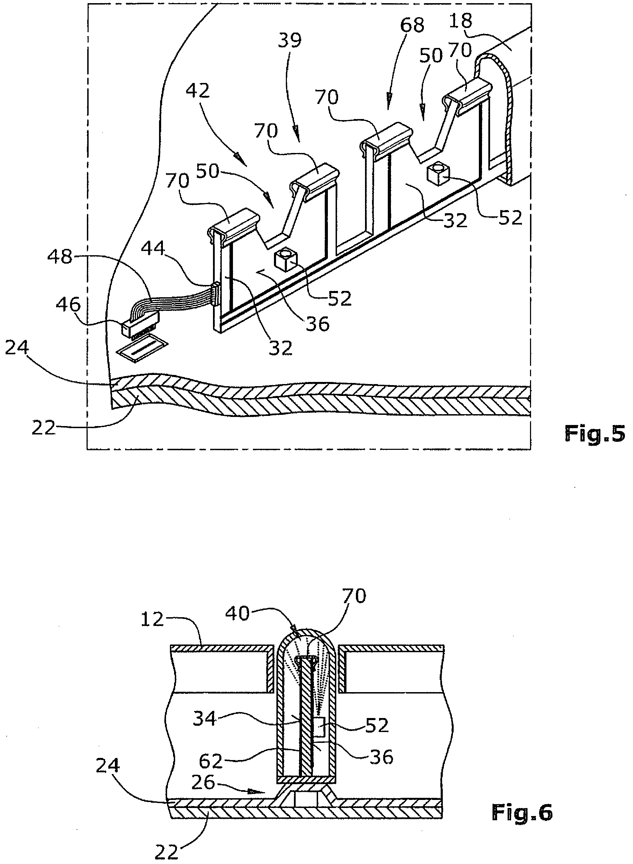

Bei dem Ausfuhrungsbeispiel gemäß den Fign. 5 und 6 weist der Näherungssensor 68 zur Vergrößerung der Sensorelektrodenfläche auf den Sensorelektrodenrandabschnitt 39 aufgesteckte elektrisch leitende Klammern 70 auf.

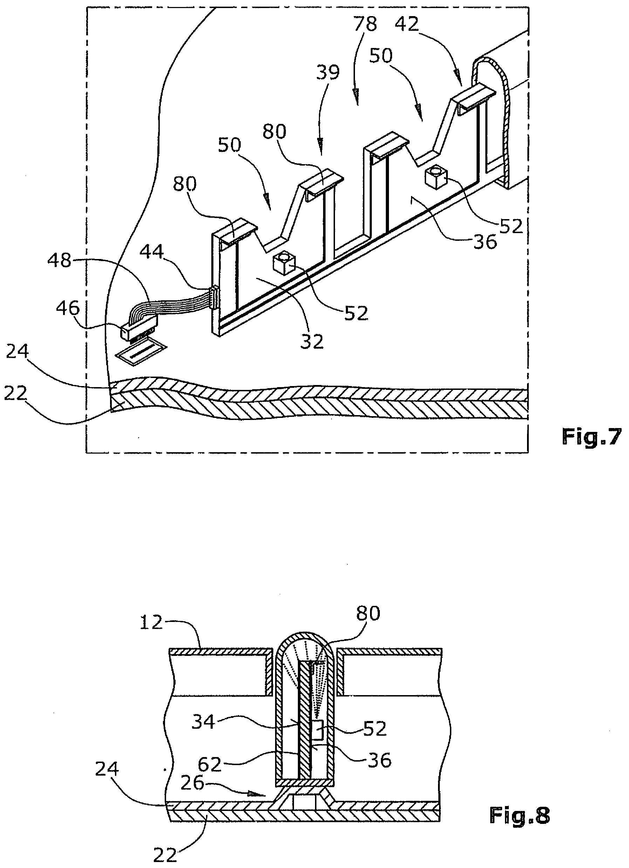

Im Biespiel gemäß den Fign. 7 und 8 sind diese Klammern ersetzt durch Winkelstücke 80, die die Flächen der Sensorelektroden 42 des Näherungssensors 78 der Fign. 7 und 8 vergrößern. Auch kann wiederum auf einer Seite der Sensorplatine 32 eine Abschirmelektrode 62 ausgebildet sein.

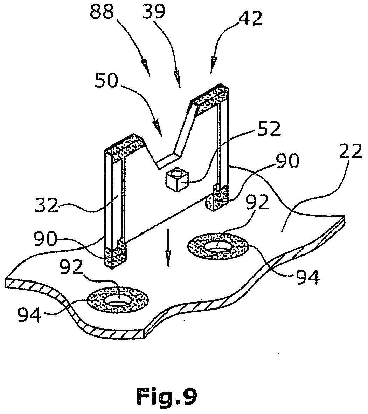

Schließlich zeigt Fig. 9 eine Möglichkeit der elektrischen Kontaktierung (und mechanischen Halterung) der Sensorplatine 32 auf der Hauptleiterplatine 22. Die Sensorelektroden 42, die gemäß Fig. 9 so, wie beispielsweise in den Fign. 1 und 2 gezeigt, ausgebildet sind, sind über Leiterbahnen, die auf einer der beiden Hauptseitenflächen der Sensorplatine 32 ausgebildet sind, mit vorstehenden Anschfussbeinchen 90 der Sensorplatine 32 verbunden, die in Ausnehmungen 92 der Hauptleiterplatine 22 eingetaucht und mit Kontaktfeldern 94 beispielsweise verlötet sind, die um die Ausnehmungen 92 herum angeordnet sind.

### BEZUGSZEICHENLISTE

- 10: Bedieneinheit
- 12: Vorderwand
- 14: Drucktaste
- 16: Drucktastenkörper
- 18: Vorderwand des Drucktastenkörpers
- 20: Symbolfeld an der Vorderwand des Drucktastenkörpers
- 22: Trägerplatte
- 24: Silikon-Schaltmatte auf der Trägerplatte
- 26: Vorsprung der Schaltmatte
- 28: Näherungssensoren in dem Drucktastenkörper
- 30: Sensorträgerkörper
- 32: Sensorplatine
- 34: Hauptseitenfläche der Sensorplatine
- 36: Hauptseitenfläche der Sensorplatine
- 38: Randfläche der Sensorplatine
- 39: Sensorelektrodenrandabschnitt
- 40: elektrisch leitendes Feld
- 42: Sensorelektrode
- 44: Verbinder
- 46: Verbinder
- 48: Kabel
- 50: Randaussparung in dem Sensorelektrodenrandabschnitt
- 58: Näherungssensor
- 60: Fahne als Sensorelektroden
- 62: Abschirmelektrode
- 68: Näherungssensor
- 70: Kammer als Sensorelektrode
- 78: Näherungssensor
- 80: Winkelstuck als Sensorelektrode
- 90: Anschlussbeinchen
- 92: Ausnehmungen
- 94: Kontaktfelder

## Patentansprüche

1. Bedieneinheit für eine Fahrzeugkomponente, insbesondere für ein Radio, ein CD- und/oder DVD-Abspielgerät, ein Navigationsgerät, ein Infotainment-Gerät, ein Heizungs- oder Klimasteuergerät oder für ein Mensch-Maschine-Interface, mit
- einer Vorderwand (12), auf der mindestens ein Symbolfeld (20) angeordnet ist, und
- einem hinter der Vorderwand (12) befindlichen und dem Symbolfeld (20) zugeordneten Näherungssensor (28) zur Erfassung einer Berührung des Symbolfeldes (20) durch ein Objekt, insbesondere den Finger einer Hand,
- wobei der Näherungssensor (28) einen Sensorträgerkörper (30) mit einer Sensorplatine (32) und mindestens einer Sensorelektrode (42) aufweist,
**dadurch gekennzeichnet,**
- **dass** die Sensorplatine (32) einen Sensorelektrodenrandabschnitt (39) aufweist, der von einer die beiden gegenüberliegenden Hauptseitenflächen (34,36) der Sensorplatine (32) verbindenden Randfläche (38) und den an diese angrenzenden Bereichen der Hauptseitenflächen (34,36) gebildet ist und
- **dass** die mindestens eine Sensorelektrode eine elektrisch leitende Fläche (40) aufweist, die sich am Sensorelektrodenrandabschnitt (39) der Sensorplatine (32) außen über die zwei gegenüberliegenden Hauptseitenflächen (34,36) und außen über die diese Hauptseitenflächen (34,36) verbindende Randfläche (38) der Sensorplatine (32) erstreckt,
- wobei die Sensorplatine (32) im Wesentlichen rechtwinklig zur Erstreckung der Vorderwand (12) verläuft und eine die beiden gegenüberliegenden Hauptseitenflächen (34,36) der Sensorplatine (32) verbindende Randfläche (38) der Sensorplatine (32) deren zur Vorderwand (12) nächstliegender Bereich ist und zum Symbolfeld weist.

2. Bedieneinheit nach Anspruch 1, **dadurch gekennzeichnet, dass** das mindestens eine Symbolfeld (20) an einem Drucktastenkörper (16) einer an der Vorderwand (12) angeordneten Drucktaste (14) ausgebildet ist und dass die Sensorplatine (32) in dem Drucktastenkörper (16) angeordnet ist.

3. Bedieneinheit nach Anspruch 1 oder 2, **dadurch gekennzeichnet, dass** an der Vorderwand (12) mehrere Symbolfelder (20) neben- oder übereinander angeordnet sind und dass der Sensorelektrodenrandabschnitt (39) der Sensorplatine (32) sich entlang der Symbolfelder (20) erstreckt und für jedes Symbolfeld (20) mindestens eine Sensorelektrode (42) aufweist.

4. Bedieneinheit nach Anspruch 2 und 3, **dadurch gekennzeichnet, dass** die mehreren Symbolfelder (20) an dem Drucktastenkörper (16) angeordnet sind.

5. Bedieneinheit nach einem der Ansprüche 1 bis 4, **dadurch gekennzeichnet, dass** der Sensorelektrodenrandabschnitt (39) der Sensorplatine (32)eine Randaussparung (50) mit einem gegenüber der Sensorelektrode (42) zurückspringenden Randabschnitt aufweist und dass auf mindestens einer der beiden gegenüberliegenden Hauptseitenflächen (34,36) der Sensorplatine (32) nahe dem zurückspringenden Randabschnitt eine Symbolfeld-Hinterleuchtungslichtquelle (52) mit einer optischen Lichthauptabstrahlachse angeordnet ist, die im Wesentlichen parallel zur Erstreckung der Sensorplatine (32) und über den zurückspringenden Randabschnitt hinaus verläuft.

6. Bedieneinheit nach einem der Ansprüche 1 bis 5, **dadurch gekennzeichnet, dass** auf der Sensorplatine (32) eine Abschirmelektrode (62) ausgebildet ist, die einer Sensorelektrode (42) oder mehreren Sensorelektroden (42) zugeordnet ist.

7. Bedieneinheit nach einem der Ansprüche 1 bis 6, **dadurch gekennzeichnet, dass** auf den Sensorelektrodenrandabschnitt (39) der Sensorplatine (32) zur Vergrößerung der zum Symbolfeld (20) weisenden elektrisch leitenden Sensorfläche (40,42) der Sensorelektrode (42) ein elektrisch leitendes Material aufweisendes Bauteil (60,70,80) aufgesteckt oder in anderer Weise unter im Wesentlichen quer zu den Hauptseiten (34,36) der Sensorplatine (32) gerichteten Erstreckung über die zwei gegenüberliegenden Hauptseiten (34, 36) hinaus mit dem Sensorelektrodenrandabschnitt (39) der Sensorplatine (32) verbunden ist.

8. Bedieneinheit nach einem der Ansprüche 1 bis 7, **dadurch gekennzeichnet, dass** die Sensorplatine (32) Anschlussfelder zur elektrischen Verbindung der Sensorelektrode (42) und, sofern vorhanden, der Abschirmelektrode (62) mit einer Trägerplatte aufweist.

9. Bedieneinheit nach Anspruch 8, **dadurch gekennzeichnet, dass** die Anschlussfelder elektrisch leitend mit Steckerstift- oder Steckerbuchsenelementen eines Kabelverbinders verbindbar sind oder an Randvorsprüngen der Sensorleiterplatine zum Eintauchen in Kontaktaufnahmen oder -ausnehmungen (92) der Trägerplatte (22) angeordnet sind.

## Claims

1. An operating unit for a vehicle component, particularly for a radio, a CD and/or DVD player, a navigation device, an infotainment device, a heating or air-conditioning device or a man/machine interface, said operating unit comprising
- a front wall (12) having at least one symbol field (20) arranged on it, and
- a proximity sensor (28) arranged behind the front wall (12) and allocated to the symbol field (20), said proximity sensor (28) provided for detection of a touch of the symbol field (20) by an object, particularly by a finger of a hand,
- said proximity sensor (28) comprising a sensor support body (30) having a sensor plate (32) and at least one sensor electrode (42),
**characterized in**
- **that** said sensor plate (32) comprises a sensor electrode edge portion (39) formed by an edge surface (38) connecting the two opposite main side surfaces (34,36) of the sensor plate (32) and by the areas of the main side surfaces (34,36) bordering on said edge surface (38), and
- **that** said at least one sensor electrode comprises an electrically conductive surface (40) which, on the sensor electrode edge portion (39) of the sensor plate (32), extends externally over said two opposite main side surfaces (34,36) and externally over the edge surface (38) of the sensor plate (32) connecting said two opposite main side surfaces (34,36),
- wherein the sensor plate (32) extends substantially at a right angle to the extension of the front wall (12), and an edge surface (38) of the sensor plate (32) connecting said two opposite main side surfaces (34,36) of the sensor plate (32) is formed by the area of the sensor plate (32) closest to the front wall (12) and faces toward the symbol field.

2. The operating unit according to claim 1, **characterized in that** said at least one symbol field (20) is formed on a push button body (16) of a push button (14) arranged at the front wall (12) and that the sensor plate (32) is arranged in the push button body (16).

3. The operating unit according to claim 1 or 2, **characterized in that** a plurality of symbol fields (20) are arranged next to each other or above each other on the front wall (12) and that said sensor electrode edge portion (39) of the sensor plate (32) extends along the symbol fields (20) and comprises at least one sensor electrode (42) for each symbol field (20).

4. The operating unit according to claim 2 or 3, **characterized in that** the plurality of symbol fields (20) are arranged on the push button body (16).

5. The operating unit according to any one of claims 1 to 4, **characterized in that** said sensor electrode edge portion (39) of the sensor plate (32) comprises an edge recess (50) having an edge portion recessed from the sensor electrode (42), and that, on at least one of said two opposite main side surfaces (34,36) of the sensor plate (32), a symbol field backlighting source (52) is arranged near said recessed edge portion that has an optical light main radiation axis which extends substantially parallel to the extension of the sensor plate (32) and beyond said recessed edge portion.

6. The operating unit according to any one of claims 1 to 5, **characterized in that** the sensor plate (32) has a shielding electrode (62) arranged on it that is allocated to a sensor electrode (42) or to a plurality of sensor electrodes (42).

7. The operating unit according to any one of claims 1 to 6, **characterized in that**, on said sensor electrode edge portion (39) of the sensor plate (32), for enlarging the sensor surface (40,42) of the sensor electrode (42) facing toward the symbol field (20), a component (60,70,80) comprising electrically conductive material is plugged on or is connected in another manner to said sensor electrode edge portion (39) of the sensor plate (32) while extending substantially transversely to said main sides (34,36) of the sensor plate (32) and beyond said two opposite main sides.

8. The operating unit according to any one of claims 1 to 7, **characterized in that** the sensor plate (32) comprises connection pads for electrical connection of the sensor electrode (42) and, if existing, of the shielding electrode (62) to a carrier plate.

9. The operating unit according to claim 8, **characterized in that** said connection pads are connectible in an electrically conductive manner to plug pin or plug socket elements of a cable connector or are arranged on edge projections of the sensor conductor plate for insertion into contact receiving portions or recesses (92) of the carrier plate (22).

## Revendications

1. Unité de commande pour un appareil de véhicule, notamment pour une radio, un lecteur de CD et/ou de DVD, un appareil de navigation, un appareil d'information et de divertissement, un appareil de commande de chauffage ou de climatisation, ou pour une interface homme-machine, avec
- une paroi avant (12) sur laquelle est disposé au moins un champ de symbole (20) et
- un détecteur de proximité (28) disposé derrière la paroi avant (12) et associé au champ de symbole (20), pour la détection d'un contact avec le champ de symbole (20) par un objet, notamment par le doigt d'une main,
- le détecteur de proximité (28) comprenant un corps de support de détecteur (30) avec une platine de détecteur (32) et au moins une électrode de détecteur (42),
**caractérisée en ce que**
- la platine de détecteur (32) comporte une zone de bord (39) pour électrode de détecteur qui est formée par une surface de bord (38) reliant entre elles les deux surfaces latérales principales opposées (34, 36) de la platine de détecteur (32) et par les zones attenantes à celles-ci des surfaces latérales principales (34, 36) et
- **en ce que** ladite au moins une électrode de détecteur comporte une surface (40) électriquement conductrice qui s'étend sur la zone de bord (39) pour électrode de détecteur à l'extérieur sur les deux surfaces latérales principales opposées (34, 36) et à l'extérieur sur la surface de bord (38) reliant entre elles les deux surfaces latérales principales opposées (34, 36) de la platine de détecteur (32),
- la platine de détecteur (32) s'étendant sensiblement perpendiculairement à l'étendue de la paroi avant (12) et une surface de bord (38) de la platine de détecteur (32) reliant entre elles les deux surfaces latérales principales opposées (34, 36) de la platine de détecteur (32) étant la zone la plus proche de la paroi avant (12) et étant orientée vers le champ de symbole.

2. Unité de commande selon la revendication 1, **caractérisée en ce que** ledit au moins un champ de symbole (20) est formé sur un corps de bouton-poussoir (16) d'un bouton-poussoir (14) disposé sur la paroi avant (12) et **en ce que** la platine de détecteur (32) est disposée dans le corps de bouton-poussoir (16).

3. Unité de commande selon la revendication 1 ou 2, **caractérisée en ce que** plusieurs champs de symbole (20) sont disposés sur la paroi avant (12) les uns à côté ou au-dessus des autres et **en ce que** la zone de bord (39) pour électrode de détecteur de la platine de détecteur (32) s'étend le long des champs de symbole (20) et comprend au moins une électrode de détecteur (42) pour chaque champ de symbole (20).

4. Unité de commande selon la revendication 2 et 3, **caractérisée en ce que** les plusieurs champs de symbole (20) sont disposés sur le corps de bouton-poussoir (16).

5. Unité de commande selon l'une des revendications 1 à 4, **caractérisée en ce que** la zone de bord (39) pour électrode de détecteur de la platine de détecteur (32) comprend un évidement de bord (50) avec une portion de bord en retrait par rapport à l'électrode de détecteur (42) et **en ce qu'**il est disposé sur au moins une des deux surfaces latérales principales opposées (34, 36) de la platine de détecteur (32) proche de la portion de bord en retrait, une source lumineuse de rétro-éclairage de champ de symbole (52) ayant un axe optique principal d'émission de lumière qui s'étend sensiblement parallèlement à l'étendue de la platine de détecteur (32) et au-delà de la portion de bord en retrait.

6. Unité de commande selon l'une des revendications 1 à 5, **caractérisée en ce qu'**une électrode de blindage (62) est formée sur la platine de détecteur (32), qui est associée à une électrode de détecteur (42) ou à plusieurs électrodes de détecteur (42).

7. Unité de commande selon l'une des revendications 1 à 6, **caractérisée en ce que**, sur la zone de bord (39) pour électrode de détecteur de la platine de détecteur (32), pour agrandir la surface de détecteur (40, 42) de l'électrode de détecteur (42), électriquement conductrice et orientée vers le champ de symbole (20), un composant (60, 70, 80) comportant un matériau électriquement conducteur est enfiché ou est relié d'une autre manière à la zone de bord (39) pour électrode de détecteur de la platine de détecteur (32) tout en s'étendant sensiblement transversalement aux surfaces principales (34, 36) de la platine de détecteur (32) et au-delà des deux surfaces principales (34, 36) opposées.

8. Unité de commande selon l'une des revendications 1 à 7, **caractérisée en ce que** la platine de détecteur (32) comprend des champs de connexion pour une connexion électrique de l'électrode de détecteur (42) et, le cas échéant, de l'électrode de blindage (62), avec une plaque de support.

9. Unité de commande selon la revendication 8, **caractérisée en ce que** les champs de connexion sont conformés pour être connectés de manière électriquement conductrice à des éléments formant broches d'enfichage ou douilles d'enfichage d'un connecteur de câble, ou sont disposés sur des saillies de bord de la platine de conducteur de détecteur pour plonger dans des prises de contact ou des évidements de contact (92) de la plaque de support (22).
